# EUROPEAN PATENT APPLICATION

(11) **EP 4 693 352 A1**
(43) Date of publication of application: **11.02.2026**
(21) Application number: 25189909.2
(22) Date of filing: 16.07.2025
(51) Int. Cl.: H01F 27/28, H10W 76/47, H05K 1/14, H05K 1/16

(54) **WINDING-LESS TRANSFORMER ASSEMBLIES AND RELATED FABRICATION METHODS**

(30) Priority: 22.07.2024 US 202418779495
(71) Applicant: Allegro MicroSystems, LLC, Manchester, NH 03103-3353 (US)
(72) Inventor: DAVID, Paul A., Bow, 03304 (US); MANGTANI, Vijay, Nashua, 03062 (US)
(74) Representative: South, Nicholas Geoffrey

(57) **Abstract**

Systems, structures, packages, circuits, and methods provide winding-less transformer structures, sub-assemblies and assemblies. Larger substate panels, e.g., a PCB or other type of substrate, can be constructed with designated locations in smaller subunits for transformer cores, which when placed at those designated locations create portions of transformers. The cores can be affixed onto the larger panels, which can then be partitioned or broken into smaller parts that can each form a subassembly. The subassemblies can then be combined with appropriate matching structures to complete the coil structures for the transformers. One or more integrated circuits such as gate drivers may be included with transformer sub-assemblies, assemblies, packages or modules.

## Description

### BACKGROUND

Solid state switches typically include a transistor structure. The controlling electrode of the switch, usually referred to as its gate (or base), is typically controlled (driven) by a switch drive circuit, sometimes also referred to as gate drive circuit. Such solid state switches are typically voltage-controlled, turning on when the gate voltage exceeds a manufacturer-specific threshold voltage by a margin, and turning off when the gate voltage remains below the threshold voltage by a margin.

Switch drive circuits typically receive their control instructions from a controller such as a pulse-width-modulated (PWM) controller via one or more switch driver inputs. Switch drive circuits deliver their drive signals directly (or indirectly via networks of active and passive components) to the respective terminals of the switch (gate and source).

Some electronic systems, including ones with solid state switches, have employed galvanic isolation to separate voltage potentials. Such galvanic isolation can be used to separate circuits in order to protect users from coming into direct contact with hazardous voltages.

Various transmission techniques are available for signals to be sent across galvanic isolation barriers including optical, capacitive, and magnetic coupling techniques. Magnetic coupling typically relies on use of a transformer to magnetically couple circuits on the different sides of the transformer, typically referred to as the primary and secondary sides, while also providing galvanic separation of the circuits.

Transformers used for magnetic-coupling isolation barriers typically utilize a magnetic core to provide a magnetic path to channel flux created by the currents flowing in the primary and secondary sides of the transformer. Magnetic-coupling isolation barriers have been shown to have various drawbacks, including manufacturing and longevity problems, for integrated circuit (IC) packages due to the included magnetic core and typically included wire coil windings.

### SUMMARY

Aspects of the present disclosure are directed to winding-less transformer assemblies, packages, and related fabrication methods.

One general aspect of the present disclosure includes a transformer package having fractional coil components. The transformer package can include: a first substrate having opposed first and second surfaces, and including a first plurality of conductive traces; a magnetic core including soft ferromagnetic material, where the magnetic core includes an aperture receiving a portion of the first substrate; and a second substrate having opposed first and second surfaces, and including a second plurality of conductive traces; where the first plurality of conductive traces and the second plurality of conductive traces are configured when in contact with each other to form first and second coils configured about the magnetic core.

Implementations may include one or more of the following features. The transformer package may include an encapsulant disposed about at least a portion of the first substrate, the second substrate, or the magnetic core. The encapsulant forms one or more surfaces of a package body. The encapsulant may include a molding material. The aperture may include first and second apertures and where the first substrate includes two portions received by the first and second apertures, respectively. The second substrate may include a recess configured to receive the magnetic core. The first substrate and/or second substrate may include a printed circuit board (PCB). The transformer package may include one or more integrated circuit (IC) die connected to the first coil and/or second coil. The first and second coils can be configured as a step up transformer, step down transformer, or a power transformer; the one or more IC die may include a gate driver connected to the second coil. The transformer package may include a third substrate configured to support the first substrate and the second substrate. The third substrate may include a lead frame. The transformer package may include an adhesive disposed between the first substrate and core portion for facilitating affixing of the magnetic core to the first substrate. The magnetic core may include ferrite.

One general aspect includes a method of making a transformer package having fractional coil components. The method can include: providing a first substrate having first and second surfaces and including a first plurality of conductive traces; providing a magnetic core having an aperture configured to receive the first substrate, where the magnetic core includes a soft ferromagnetic material; affixing the magnetic core to the first substrate; providing a second substrate having opposed first and second surfaces and a second plurality of conductive traces; and connecting the first plurality of conductive traces and the second plurality of conductive traces, where the first and second pluralities of conductive traces form first and second coils configured about the magnetic core.

Implementations may include one or more of the following features. The method may include providing one or more IC die connected to the first and/or second coils. The method may include applying an encapsulant disposed about at least a portion of the first substrate, the second substrate, and/or the magnetic core. The encapsulant forms one or more surfaces of a package body. The encapsulant may include a molding material. The aperture may include first and second apertures and where the first substrate includes two portions received by the first and second apertures, respectively. The second substrate may include a recess configured to receive the magnetic core. The first substrate and/or second substrate may include a printed circuit board (PCB). The method may include providing one or more integrated circuit (IC) die connected to the first coil and/or second coil. The first and second coils can be configured as a step up transformer, a step down transformer, or a power transformer; the one or more IC die may include a gate driver connected to the second coil. The method may include providing a third substrate configured to support the first substrate and the second substrate. The third substrate may include a lead frame. The method may include providing an adhesive disposed between the first substrate and the magnetic core for facilitating affixing of the magnetic core to the first substrate. The magnetic core may include ferrite.

The features and advantages described herein are not all-inclusive; many additional features and advantages will be apparent to one of ordinary skill in the art in view of the drawings, specification, and claims. Moreover, it should be noted that the language used in the specification has been selected principally for readability and instructional purposes, and not to limit in any way the scope of the present disclosure, which is susceptible of many embodiments. What follows is illustrative, but not exhaustive, of the scope of the present disclosure.

### BRIEF DESCRIPTION OF THE DRAWINGS

The manner and process of making and using the disclosed embodiments may be appreciated by reference to the figures of the accompanying drawings. In the figures like reference characters refer to like components, parts, elements, or steps/actions; however, similar components, parts, elements, and steps/actions may be referenced by different reference characters in different figures. It should be appreciated that the components and structures illustrated in the figures are not necessarily to scale, emphasis instead being placed upon illustrating the principals of the concepts described herein. Furthermore, embodiments are illustrated by way of example and not limitation in the figures, in which:
FIGS. 1A-1C are diagrams showing example winding-less transformer assemblies utilizing single-hole cores at different stages of construction, in accordance with the present disclosure;
FIG. 2A-2C are diagram showing further example winding-less transformer assemblies utilizing three-pronged substrate structures and single-hole cores at different stages of construction, in accordance with the present disclosure;
FIGS. 3A-3D are diagrams showing examples winding-less transformer assemblies utilizing dual-hole cores at different stages of construction, in accordance with the present disclosure;
FIGS. 4A-4D are diagrams showing further examples of winding-less transformer assemblies utilizing dual-hole cores at different stages of construction, in accordance with the present disclosure;
FIGS. 5A-5D show cross-section views of winding-less transformer assemblies including IC die, in accordance with the present disclosure;
FIG. 6 is a cross-section view of an example winding-less transformer structure mounted on a main IC package, in accordance with the present disclosure; and
FIG. 7 is a diagram showing an example method of fabricating winding-less transformer assemblies, in accordance with the present disclosure.

### DETAILED DESCRIPTION

The features and advantages described herein are not all-inclusive; many additional features and advantages will be apparent to one of ordinary skill in the art in view of the drawings, specification, and claims. Moreover, it should be noted that the language used in the specification has been selected principally for readability and instructional purposes, and not to limit in any way the scope of the inventive subject matter. The subject technology is susceptible of many embodiments. What follows is illustrative, but not exhaustive, of the scope of the subject technology.

Aspects, examples, and embodiments of the present disclosure are directed to and include winding-less transformer assemblies (a.k.a., sub-assemblies), structures, and packages and related fabrication methods. Winding-less transformer structures are provided, e.g., as assembly or subassemblies, which contain conductive structures forming parts of transformer coils-without utilizing wire windings for the coils-and that also accommodate part of the transformer core.

In some embodiments, larger substate panels (e.g., a PCB or other type of substrate) can be constructed with designated locations (e.g., "insert slots") in smaller subunits (sub-panels) for transformer cores, which when placed at those designated locations create portions of transformers. The cores can be affixed (e.g., glued or using another process) onto the larger panel (e.g., PCB or other material), which can then be partitioned or broken into smaller parts that can each form a subassembly. The subassemblies can then be combined with appropriate matching structures to complete the coil structures for the transformers. Because of the lack of wire windings, such transformer structures/techniques can provide reduced cost and/or robustness for isolated gate drivers or other galvanically isolated ICs.

Such assemblies, structures, and packages can be used for systems, structures, and circuits for galvanic isolation (a.k.a., voltage isolation), e.g., for high-voltage applications. In some embodiments, a transformer with a core may have, e.g., a step up, a step down, or a power transformer configuration. In some embodiments, a transformer may have multiple input and/or output coils/coil structures.

The transformer assemblies and packages (modules) may include various types of circuits (e.g., ICs); in some examples, transformer packages with ICs may include a galvanically isolated gate driver or other high voltage circuit, etc. One or more (e.g., first and second) semiconductor die having one or more integrated circuits (a.k.a., "IC die") can be included in the packages and assemblies. Such integrated circuits can include, e.g., but are not limited to, high-voltage circuits such as galvanically-isolated gate drivers configured to drive an external gate on a solid-state (semiconductor) switch, e.g., a field effect transistor (FET), a metal oxide semiconductor (MOS) FET (MOSFET), a metal semiconductor FET (MESFET), a gallium nitride FET (GaN FET), a high electron mobility transistor (HEMT), a silicon carbide FET (SiC FET), an insulated gate bipolar transistor (IGBT), or another load.

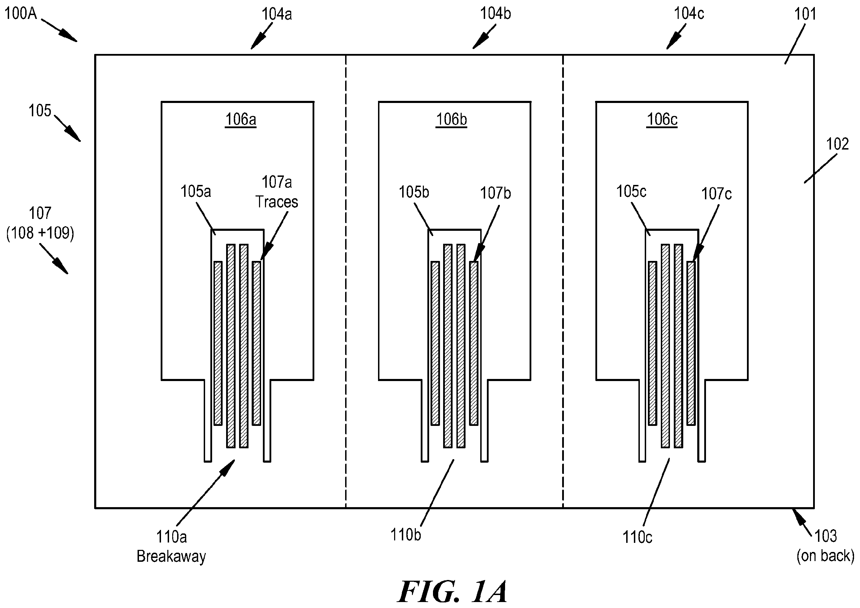

FIGS. 1A-1C are diagrams showing example winding-less transformer assemblies utilizing single-hole cores at different stages of construction, in accordance with the present disclosure.

FIG. 1A shows transformer assembly 100A including substrate 101 with opposed first and second sides 102, 103. Substrate 101 can be any suitable substrate, e.g., a printed circuit board (PCB), in some embodiments. Assembly 100A includes multiple subunits 104a-c, formed from substrate 101, which can be processed to form transformer sub-assemblies, as described below.

Subunits 104a-c include respective smaller substrates 105a-c within apertures 106a-c formed in subunits 104a-104c. Breakaway portions 110a-c of subunits 104a-104c can be configured/designed to facilitate separation of substrates 105a-c, respectively.

Substrate 101 includes pluralities of conductive traces (conductive structures), including pluralities 107a-107c for substrates 105a-c, respectively. The conductive traces 107a-c may be within and/or on a substrate, e.g., substrate 101 and/or substrates 104a-c. Each plurality of conductive traces 107a-c can include conductive traces (e.g., a first set or group of traces 108) for a first (e.g., primary) coil of the related transformer and conductive traces (e.g., a second set or group of traces 109) for a second (e.g., secondary) coil of the related transformer. Of course, additional sets or groups of conductive traces may be included, e.g., in embodiments where multiple primary and/or secondary coils are present.

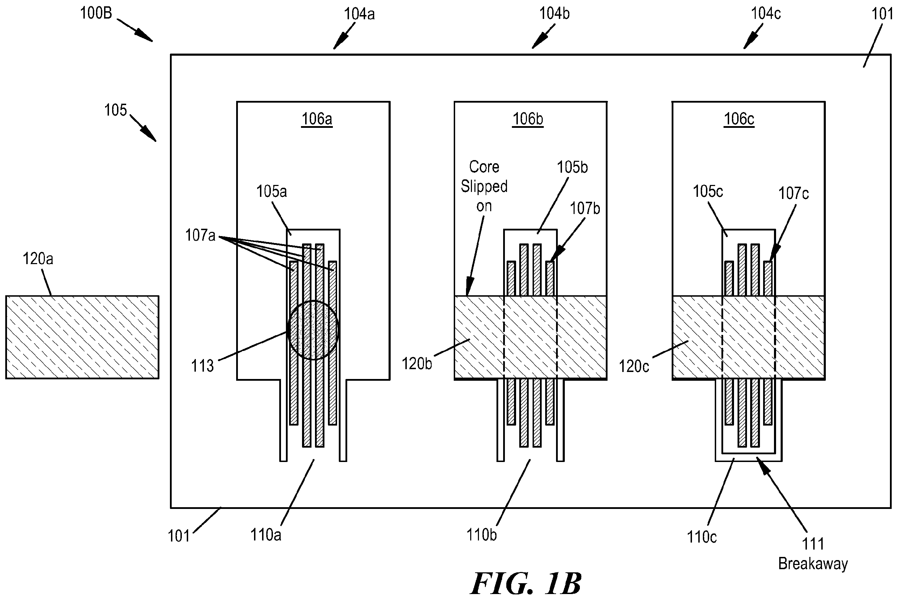

FIG. 1B shows assembly structure 100B with magnetic cores 120a-c present for subunits 104a-c, respectively. In some embodiments, any suitable soft (magnetic property) ferromagnetic material may be used for magnetic cores 110a-c. Examples include, but are not limited to, ferrite (solid or sintered), ferrosilicon, nickel, nickel alloys (e.g., iron nickel), and/or the like. In some embodiments, magnetic cores 120a-c may have shapes including closed loops of various geometries, e.g., rectangular loops, ellipsoidal loops, square loops, circular loops, etc. Magnetic cores 120b-c are shown placed around substrate portions 105b-c, respectively. In some embodiments, insulative adhesive may be used between a magnetic core (e.g., 120a) and the corresponding substrate portion, e.g., as shown by adhesive 113 on substrate portion 105a.

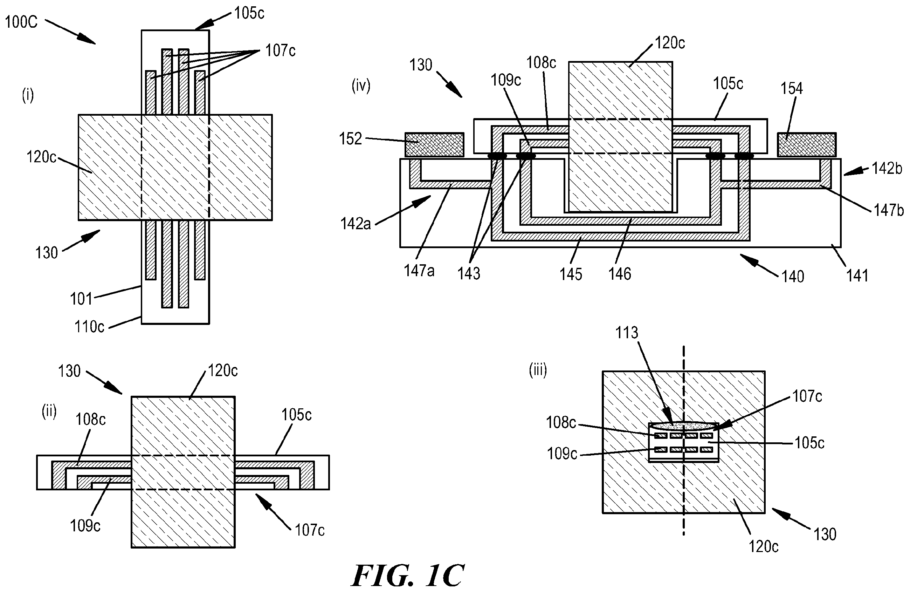

FIG. 1C includes views (i)-(iv) showing top, side cross section, end cross section, and assembled views of assembly 100C. Assembly 100C includes a substrate portion 105c (of subunit 104c shown in FIG. 1B) mounted with magnetic core 120c, together forming mounted core structure 130c. Conductive traces 107c are shown in/on substrate portion 105c, portions 108c, 109c for utilization in galvanically separated primary and secondary transformer coil structures. Breakaway portion 110c is also shown, indicating where portion 104c was severed (broken) from original (larger) substrate 101, shown in FIG. 1B.

View (iv) shows an assembled view (side cross-section) of assembly 100C with mounted core structure 130c itself mounted to another assembly structure 140 (e.g., a second or main substrate structure) having second substrate 141 and additional components. One or more ICs, e.g., first and second ICs 152, 154, can be mounted to substrate 141, as shown. Substrate 141 can include a plurality of conductive traces, including two groups 142a and 142b that can be used to form galvanically separated primary and secondary coil structures when combined with (e.g., conductively coupled to) conductive traces 108c and 109c of mounted core structure 130c-to form complete primary and secondary coils configured about core 120c. ICs 152 and 154 are shown coupled to conductive traces 147a and 147b by conductive traces 149a and 149b, respectively.

Conductive adhesive or solder (indicated by solder bumps 143) may be used to facilitate connection of the portions of the primary and secondary coil structures of mounted core structure 130 and main substrate structure 140, in some embodiments. In some embodiments, one of the ICs, e.g., IC 154, can be or include a gate driver configured to control operation of a semiconductor power switch, e.g., GaN, MOS, and/or SiC power device (transistor). In some embodiments, cores 120a-120c can include one or more soft (magnetic property) ferromagnetic materials, e.g., ferrite, a nickel alloy, nickel-iron (NiFe) and/or silicon-iron (SiFe), etc., and may have a closed shape, e.g., a toroidal or rectangular shape, as indicated. In some embodiments, an insulator material can be provided to the magnetic core to provide isolation. In some embodiments, the core may be insulated with an insulating tape on the core side(s)/surface(s) facing an adjacent substrate or substrates. In some embodiments, a substrate (e.g., a PCB) can have solder or wirebond locations for interconnection with another system or circuit, e.g., a secondary circuit with IC on another substrate.

In some embodiments, a core in the form of a simple toroid can be placed over a substrate having a simple PCB structure having just single traces passing through the core. This substrate may have bends on one end so it is wider giving an interface point to allow spreading the contact locations. This configuration could be used in a single wrapped core process, in some embodiments.

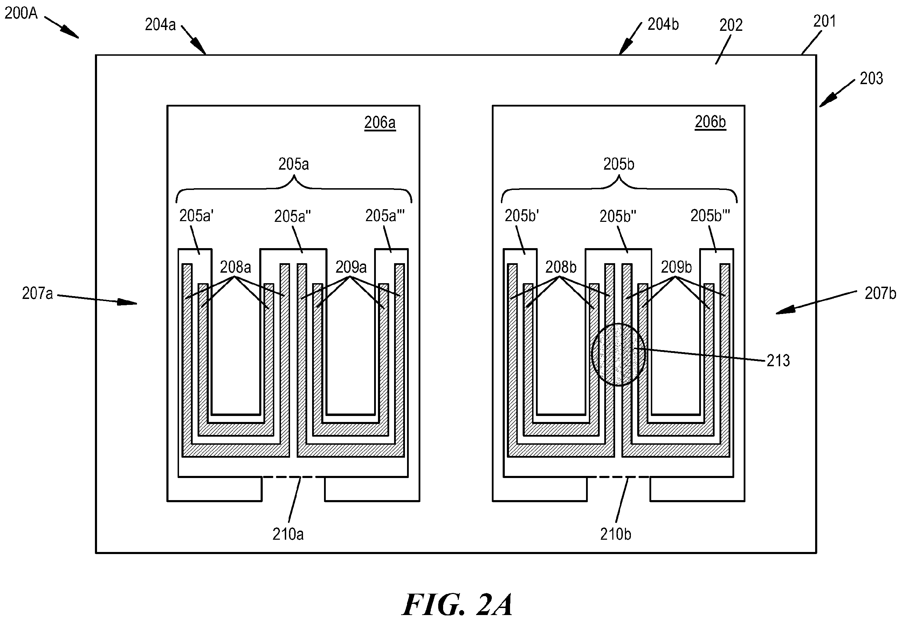

FIG. 2A-2C are diagram showing further example winding-less transformer assemblies 200A-200C three-pronged substrate structures and single-hole cores at different stages of construction, in accordance with the present disclosure.

FIG. 2A shows transformer assembly 200A, which is similar to assembly 100A of FIG. 1A, but includes a substrate 201 (with first and second sides 202, 203) shown as having two subunits (e.g., panels) 204a-b. The subunits 204a-b include smaller substrates 205a-b having an "E" shape with three prongs (205a', 205", 205,"' and 205b', 205b", 205b‴), respectively, with respective cores receiving the center prongs, as described in further detail below.

Substrates 205a-b can be formed within subunits 204a-b (e.g., sub-panels) of substrate 201 by formation of apertures 206a-b. Apertures 206a-c can be formed by any suitable techniques (e.g., sawing, laser cutting, etching, etc.). Breakaway portions 210a-b can be configured/designed to facilitate separation of substrates 205a-b, respectively, from substrate 201. Substrates 205a-b includes pluralities of conductive traces (conductive structures) 207a-207b, respectively. The conductive traces 207a-b may be within and/or on substrate 205a-b, e.g., disposed at one or more layers of substrates 205a-b. As shown, each of the pluralities of conductive traces 207a-b can include first and second group 208a-b and 209a-b, which can be used for a first (primary) and second (secondary) coils of the related transformer. Of course, additional sets or groups of conductive traces may be included, e.g., in embodiments where multiple primary and/or secondary coils are present.

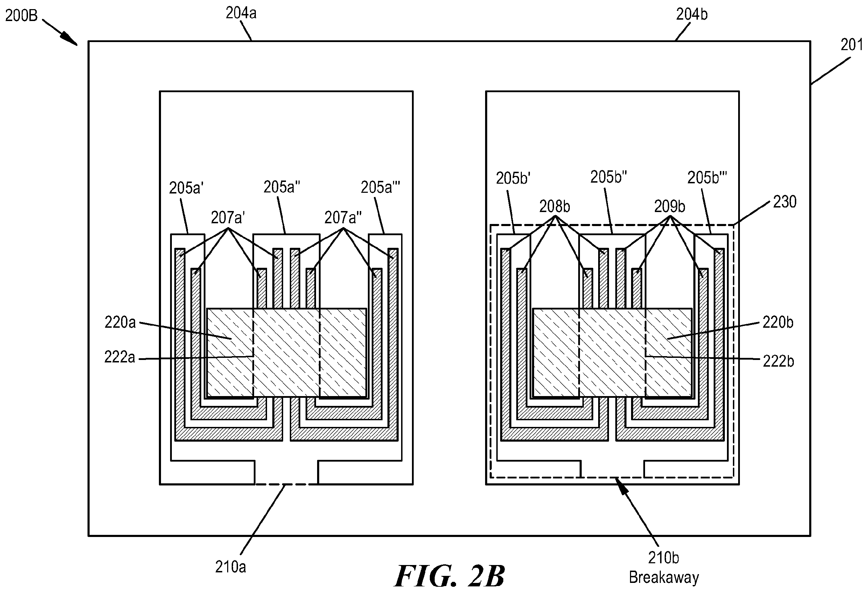

FIG. 2B shows assembly200B including magnetic cores 220a-b present for subunits 204a-b, respectively. Magnetic cores 220a-b can have a single hole or aperture 222a-b, as shown In some embodiments, magnetic cores 220a-b may have shapes including closed loops of various geometries, e.g., rectangular loops, ellipsoidal loops, square loops, circular loops, etc. As noted above, magnetic cores 220a-b are shown placed around central portions 205a"-b" of substrates 205a-b, respectively, with the outer prongs flanking cores 220b-c. Any suitable soft (magnetic property) ferromagnetic material may be used for magnetic cores 210a-b. Examples include, but are not limited to, ferrite (solid or sintered), ferrosilicon, nickel, nickel alloys (e.g., iron nickel), and/or the like. In some embodiments, insulative adhesive (e.g., shown as 213 in FIG. 2A) may be used between magnetic cores 220a-b and the corresponding substrate portion 205a"-b."

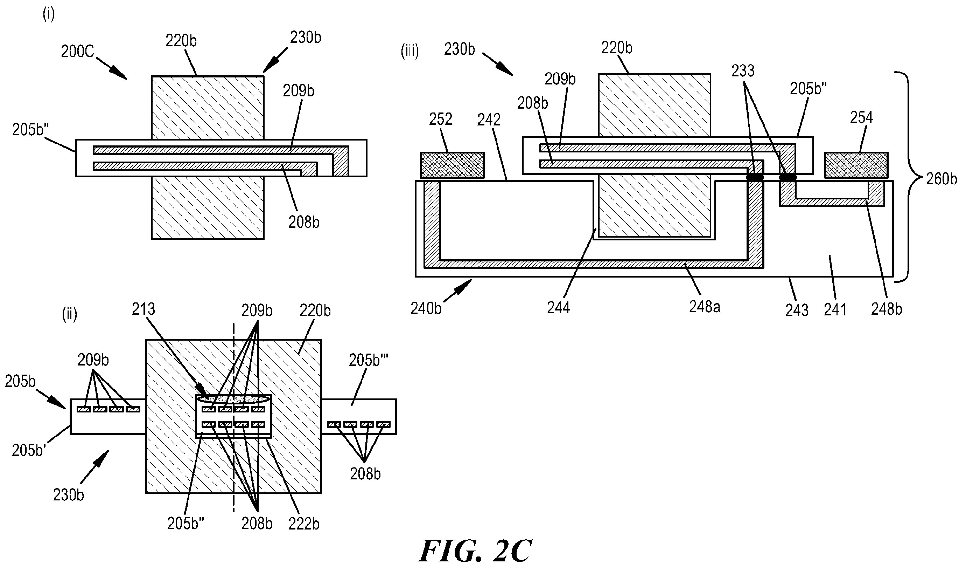

FIG. 2C includes views (i)-(iii) showing side cross section, end cross section, and assembled views of assembly 200C. Transformer assembly 200C includes substrate portion 205b (from FIG. 2B) with magnetic core 220b, together forming transformer assembly (transformer structure) 230b. Conductive traces 207b include groups 208b and 208b for utilization in primary and secondary transformer coil structures.

View (iii) shows transformer assembly 230b itself mounted to a second (main) substrate structure 240 having second substrate 241, with the combined assembly indicated 260. One or more ICs can be mounted to substrate 241, e.g., as shown by first and second ICs 252, 254. Substrate 241 can include a plurality of conductive traces, including two galvanically separate groups 248a-b that can be used to connect primary and secondary coil structures formed by groups 208b and 209b of transformer assembly 230b to ICs 252 and 254. Conductive adhesive or solder (indicated by solder bumps 233) may be used to facilitate connection of the portions of the primary and secondary coil structures of transformer assembly 230b and main substrate structure 240, in some embodiments.

In some embodiments, a simple toroid core can be placed over an "E" shaped PCB structure having approximately three quarters of the traces forming the coils. This structure can be fit into a core that has a single hole (aperture), resulting in two separate partial-coil sections (i.e., sections that each include conductive structures or traces that form part of a transformer coil), of a planar core type coil structure. As described below, the coil section can be used to form transformer coils, e.g., primary and secondary coils. While substrates 205a-b are shown and described as having three prongs (i.e., an "E" shape), substrate structures with two prongs may be used, e.g., having a "C" shaped PCB structure having a substantial portion of the coil traces; one leg (prong) of the substrate can be passed through the core on one half.

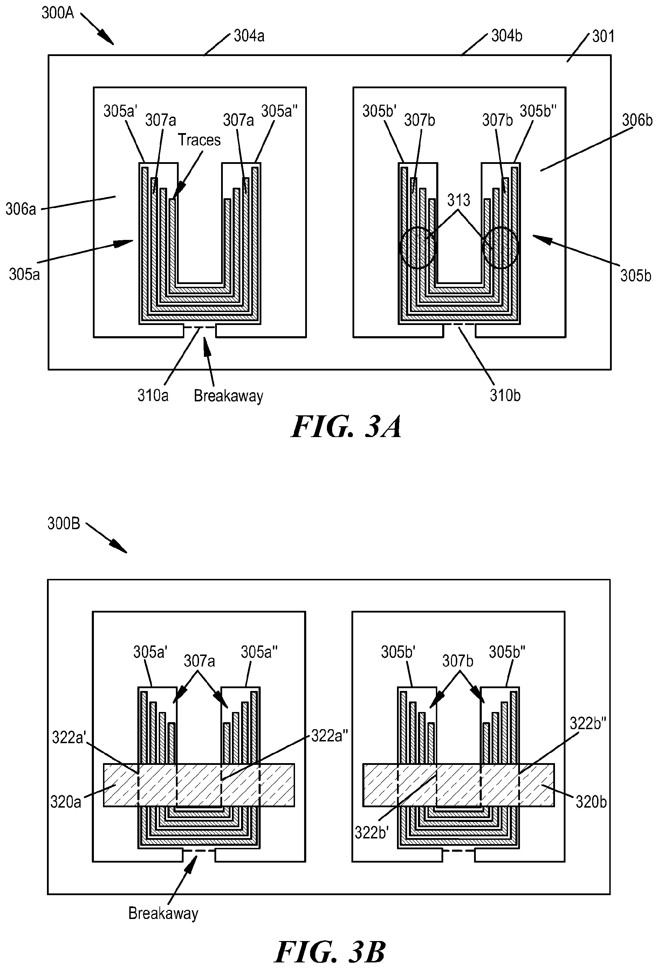

FIGS. 3A-3D are diagrams showing a further example winding-less transformer assemblies utilizing dual-hole cores 300A-300D at different stages of construction, in accordance with the present disclosure.

FIG. 3A shows transformer assembly 300A, which is similar to assembly 200A of FIG. 2A, but includes dual-prong substrates used with dual-hole cores. As shown, larger substrate 301 includes subunits 304a-b include smaller substrates 305a-b, each having a "C" shape with two prongs (405a', 405" and 405b', 405b"), respectively, which are configured to be received by the dual-holes cores, as described in further detail below.

Substrates 305a-b can be formed within subunits 304a-b of larger substrate 301 by formation of apertures 306a-b in subunits 304a-304b (a.k.a., sub-panels). Breakaway portions 310a-b can be configured/designed (e.g., by etching, milling, etc.) to facilitate separation of substrates 305a-b, respectively, from substrate 301. Substrates 305a-b include pluralities of conductive traces (conductive structures) 307a-b, respectively. The conductive traces 307a-b may be within and/or on substrates 305a-b, e.g., disposed at one or more layers of substrates 305a-b. In some embodiments, adhesive material 313 (e.g., glue, epoxy, or other insulative adhesive) may be present on prongs of the substrates to facilitate fixation or mounting to the magnetic cores.

FIG. 3B shows assembly 300B with magnetic cores 320a-b mounted to/disposed on substrates 305a-b, respectively. Cores 320a-b have two apertures (holes) apiece: core 320a is shown with apertures 322a', 322a" and core 320b is shown with apertures 322b', 322b." Any suitable soft (magnetic property) ferromagnetic material may be used for magnetic cores 310a-b, in some embodiments. Examples include, but are not limited to, ferrite (solid or sintered), ferrosilicon, nickel, nickel alloys (e.g., iron nickel), and/or the like.

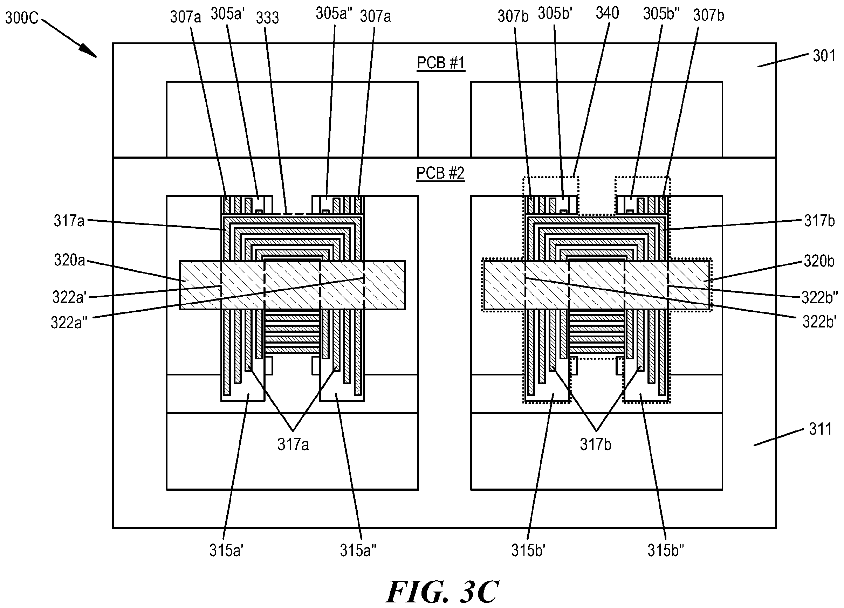

FIG. 3C shows assembly structure 300C, which includes an additional substrate 311 with smaller multi-prong substrates 315a-b positioned adjacent to substrates 305a-b. As shown, substrates 315a-b can include two prongs each, i.e., prongs 315a', 315a" and 315b', 315b", respectively, which are received/placed in the dual apertures of cores 320a-b (as are those of substrates 305a-b). Breakaway portions 333 (one is shown) can allow/facilitate separation of 315a-b from larger (parent) substrate 311. Substrates 315a-b may be positioned (e.g., inserted) into apertures of cores 320a-b before or after substrates 305a-b have been positioned into the apertures. Placement of both substrates 305a-b and 315a-b in cores 320a-b results in transformer assembly 340 after separation of those substrates from their respective parent substrate 301 and 311, respectively.

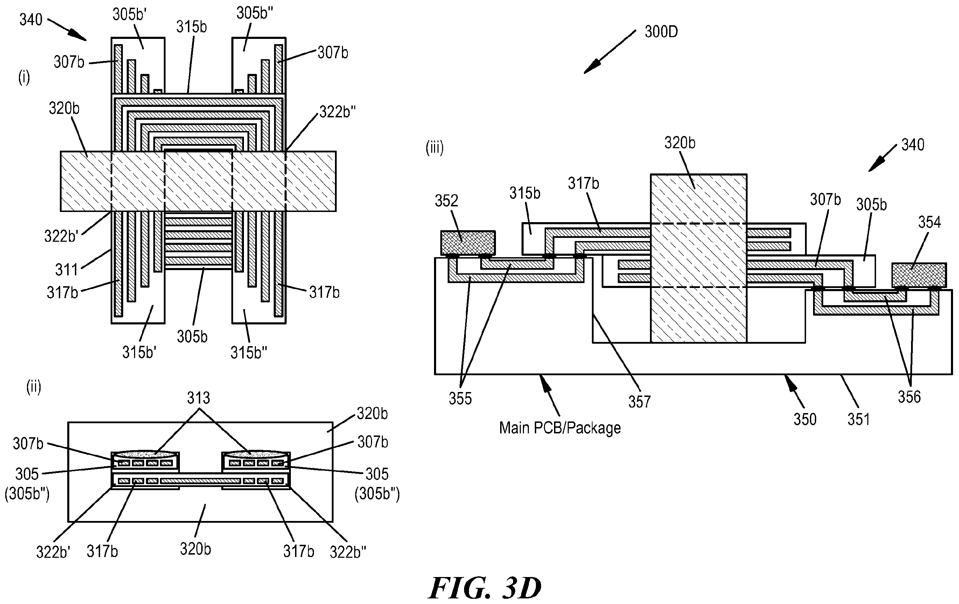

FIG. 3D includes views (i)-(iii) showing side cross section, end cross section, and assembled views of assembly structure 300D, which includes transformer assembly 340 (from FIG. 3C). View (i) shows substrates 305b and 315b placed through apertures (holes) 322b', 322b" of core 320b.

View (ii) shows optional insulative adhesive 313 used to facilitate placement of core 320b about substrate 301; adhesive 313 could also or instead be used on substrate 311, in some embodiments.

View (iii) shows transformer assembly 340 configured with (e.g., mounted or connected to) another substrate structure 350, e.g., which can be a master PCB or PCB package. Substrate structure can include a main substrate 351 and one or more ICs, e.g., shown as packaged ICs 352, 354. Main substrate 351 is configured to receive substrates 305 and 315 of transformer assembly 340, as shown. Main substrate 351 includes two pluralities (groups) of conductive structures (e.g., traces) 355, 356 that are connected to the conductive structures (traces) 307b, 317b, respectively, to form complete first and second coils for the related transformer (including core 320b). Traces 355, 356 and/or 307b, 317b may include connections (not shown) to provide coil "loops" that are electrically configured in series or parallel, in some embodiments. In some embodiments, the transformer formed may have a step-up transformer configuration. In some embodiments, an IC connected to the secondary side of a step-up transformer configuration may include a gate driver.

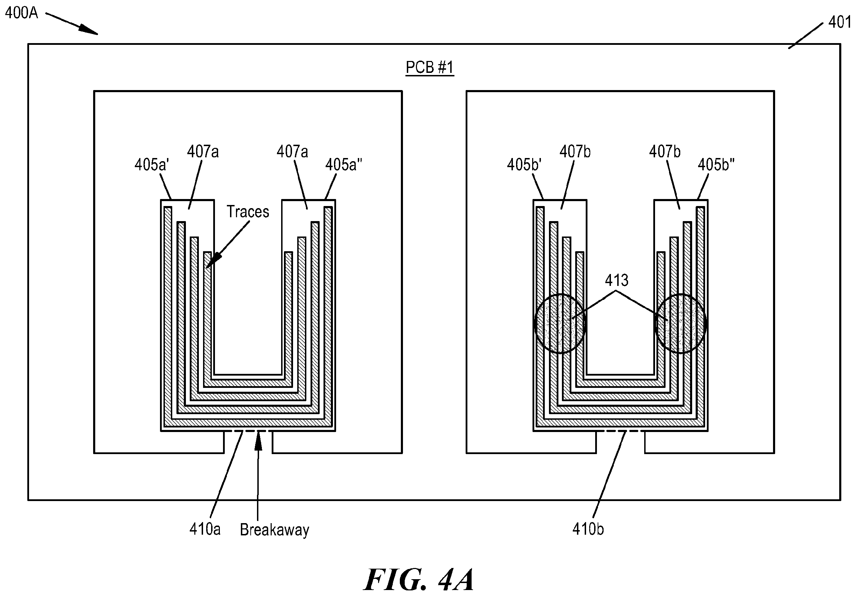

FIGS. 4A-4D are diagrams showing another example of winding-less transformer assemblies 400A-400D utilizing dual-hole cores at different stages of construction, in accordance with the present disclosure. Assemblies 400A-400D are similar to those shown for FIGS. 3A-3D embodiments, construction like above, but utilize a smaller substrate (e.g., PCB) to complete coil loops of one transformer coil.

FIG. 4A shows assembly 400A including dual-prong substrates used with dual-hole cores. As shown, larger substrate 401 includes subunits 404a-b include smaller substrates 405a-b having a "C" shape with two prongs (405a', 405" and 405b', 405b"), respectively, which are configured to be received by dual-hole cores, as described in further detail below.

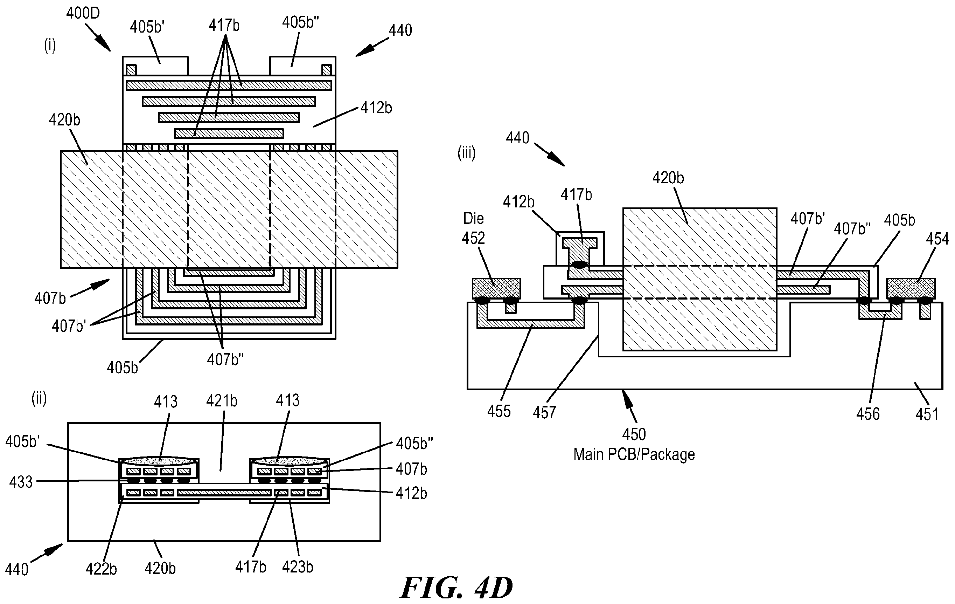

Substrates 405a-b can be formed within substrate subunits 404a-b by formation of apertures 406a-b, selectively removing material from larger substrate 401 (e.g., PCB panel). Breakaway portions 410a-b can be configured/designed to facilitate separation of substrates 405a-b, respectively, from substrate 401. Substrates 405a-b includes pluralities of conductive traces (conductive structures) 407a-b, respectively, for use as portions of transformer coils. The conductive traces 407a-b may be within and/or on substrates 405a-b, e.g., disposed at one or more layers of substrates 405a-b. In some embodiments, adhesive material 413 (e.g., insulative glue, epoxy, etc.) may be present on prongs of the substrates 405a-b to facilitate fixation or mounting to the magnetic cores. Conductive traces 407a-b may each include two (or more) galvanically separate groups of traces that can be used for galvanically separate coils of the related transformer (see, e.g., traces 407b' and 407b" in FIG. 4D).

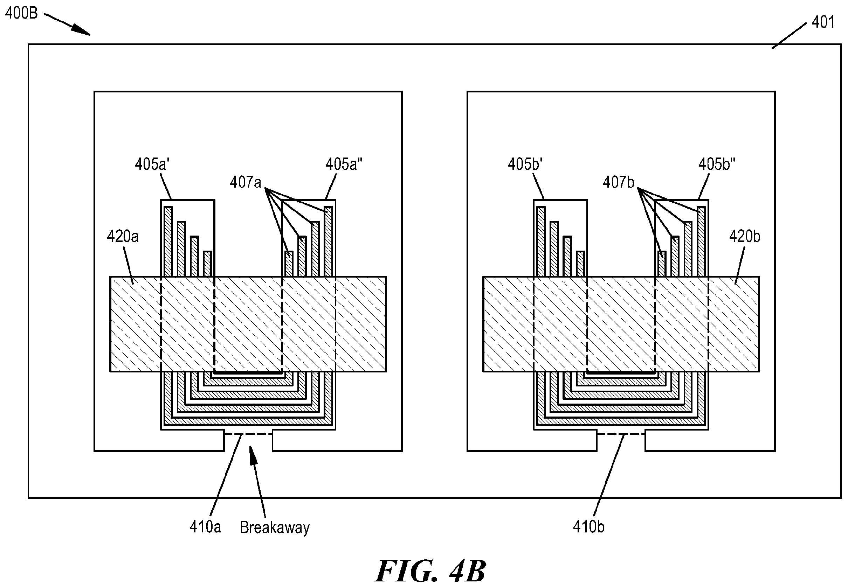

FIG. 4B shows assembly structure 400B with magnetic cores 420a-b mounted to/disposed on substrates 405a-b, respectively. Cores 420a-b have two apertures (holes) apiece: core 420a is shown with apertures 422a', 422a" and core 420b is shown with apertures 422b', 422b".

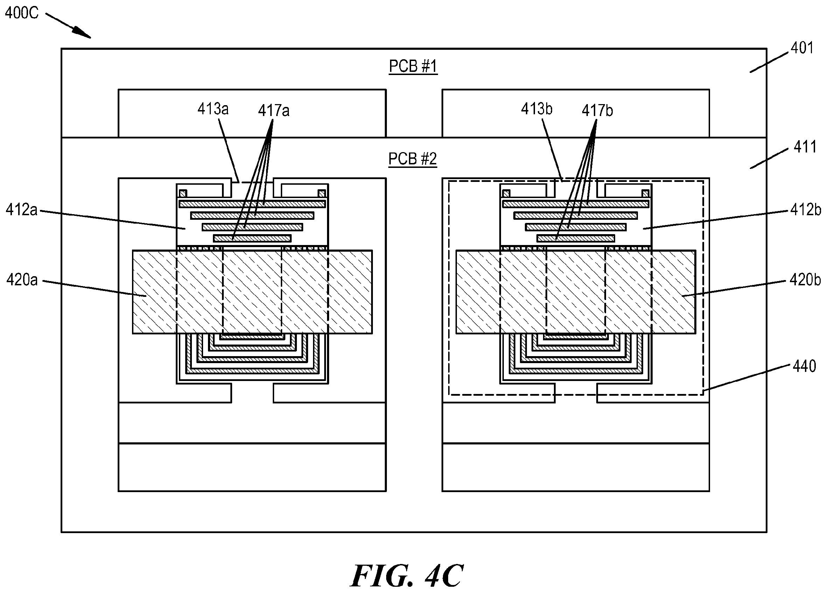

FIG. 4C shows transformer assembly structure 400C, which includes an additional substrate 411 with smaller substrates 412a-b positioned adjacent to substrates 405a-b. As shown, substrates 412a-b can each include a plurality (group) of conductive traces 417a-b. In some embodiments substrates 412a-b may have rectangular shapes as shown. Breakaway portions 413a-b can allow/facilitate separation of substrates 412a-b from larger (parent) substrate 411. Conductive traces 417a-b can be connected to traces 407a-b of substrates 405a-b to complete, e.g., a single coil of a transformer assembly, as described below. Connection of substrates 405a-b and 411a-b results in transformer assemblies 440.

FIG. 4D includes views (i)-(iii) showing top, side, end, and assembled views of assembly substructure 400D. Structure 400D includes transformer assembly 440 (from FIG. 4C). View (i) shows substrate 412b connected to prongs 405b' and 405b" of substrate 405b. By this connection, a group of conductive traces, e.g., group 407b', of traces 407b are connected to traces 417b, completing a transformer coil (e.g., a secondary coil) configured about core 420b. Another transformer coil (e.g., a primary coil) is completed by connection of traces group 407b" with conductive traces 455 in substrates 451.

View (ii) shows optional insulative adhesive 413 used to facilitate placement of core 420b about substrate 405b. View (ii) also shows optional solder balls 433 used to facilitate connection of conductive traces of substrates 405 and 412b.

View (iii) shows transformer assembly 440 configured with (e.g., mounted or connected to) another substrate structure 450, e.g., which can be a master PCB or PCB package in some embodiments. Substrate structure 450 can include a main substrate 451 and one or more ICs, e.g., shown as packaged ICs 452, 454. Main substrate 451 is configured to receive substrate 405b and core 420b of transformer assembly 440, as shown.

Main substrate 451 includes two pluralities (groups) of galvanically separate conductive structures (e.g., traces) 455, 456 that are connected to the conductive structures (traces) 407b of substrate 405b, including traces groups 407b' and 407b". When connected to traces group 407b", as shown, one plurality of traces 455 can include conductive structures (traces, pillars, etc.) to complete a coil (e.g., a primary coil) of the transformer (with another coil being completed by connection of traces group 407b" to traces 417b of substrate 412b). Traces 455, 456 and/or 407b, 417b may include connections (not shown) to provide coil "loops" that are electrically configured in series or parallel, in some embodiments. In some embodiments, the transformer formed (core 420b with the two noted coils) may have a step-up transformer configuration. In some embodiments, an IC connected to the secondary side of a step-up transformer configuration may include a gate driver. In some embodiments, substrate 451 can include a recess (e.g., aperture, depression, cavity, etc.) to facilitate receiving core 420b in a small form factor.

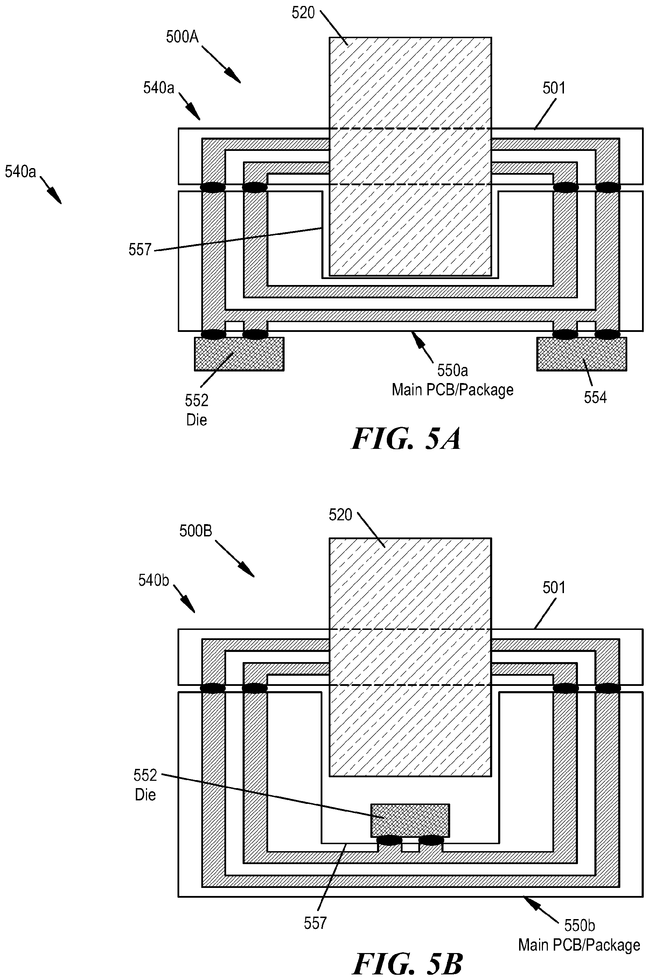

As mentioned above, substrate (e.g., PCBs) used with transformer assemblies according to the present disclosure may have one or more active IC die. In some embodiments, IC die can be placed at multiple various locations on a substrate (e.g., PCB), including, but not limited to, under a core, next to a core, on a transformer subassembly, in a slot formed in a subassembly, and/or in a recess on the main substrate. Examples are discussed below with respect to FIGS. 5A-5D, though other embodiments with IC die are within the scope of the present disclosure.

FIGS. 5A-5D show cross-section views of examples 500A-500D of winding-less transformer assemblies including IC die, in accordance with the present disclosure.

FIG. 5A shows transformer and IC die assembly 500A including a winding-less transformer assembly 540a in accordance with the present disclosure, e.g., similar to assembly 130 of FIG. 1C. Transformer assembly 540a includes substrate 501 and core 520a and is coupled to a main PCB package 550a. Main PCB package 550a includes a substrate 551 (e.g., main PCB) having an aperture/slot 557 that is configured to receive a portion of core 520a, allowing for a compact form for assembly 500A. Main PCB package 550ais shown including first and second IC die 552, 552. In some embodiments, IC die can be wire-bonded or flipped or put into a package and attached to substrate 551.

FIG. 5B shows transformer and IC die assembly 500B including a transformer assembly 540b and is generally similar to assembly 500A of FIG. 5A. Main PCB package 550b, however, includes a substrate 551 (e.g., main PCB) with a relatively larger aperture/slot 557 that is configured to receive a portion of core 520b while also allowing for the mounting of IC die 552 on substrate 551, as shown.

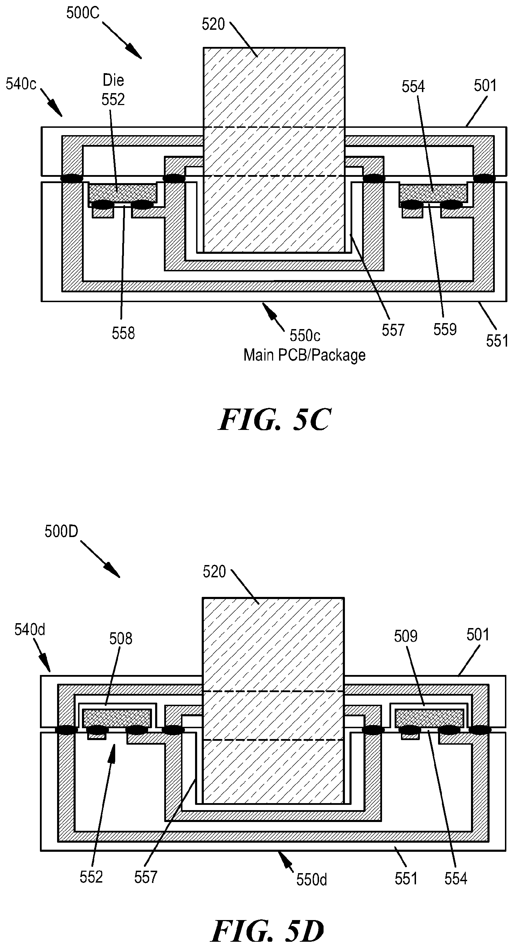

FIG. 5C shows transformer and IC die assembly 500C including a transformer assembly 540c and is generally similar to assembly 500A of FIG. 5A. Main PCB package 550c includes a substrate 551 (e.g., main PCB) with an aperture/slot 557 that is configured to receive a portion of core 520a and also includes an additional pair of apertures 558, 559 that allow mounting of IC die 552, 554 in a recessed manner, as shown.

FIG. 5D shows transformer and IC die assembly 500D including a transformer assembly 540d and is generally similar to assembly 500C of FIG. 5C. Main PCB package 550d includes a substrate 551 (e.g., main PCB) with an aperture/slot 557 that is configured to receive a portion of core 520a. Substrate 501 of the transformer assembly 540d, however, includes a pair of apertures 508, 509 that are configured to receive IC die 552, 554 mounted to main PCB package 550d, as shown.

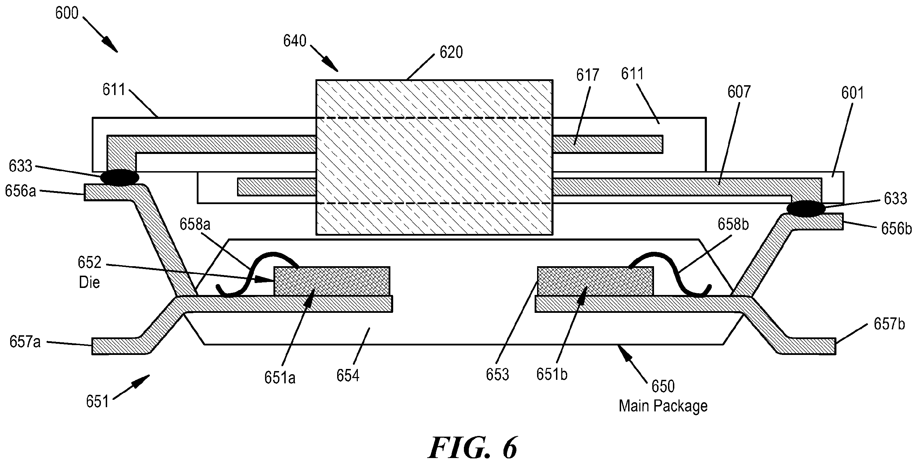

FIG. 6 is a cross-section view of an example winding-less transformer structure and IC package assembly 600, in accordance with the present disclosure.

Assembly 600 includes a winding-less transformer assembly 640 in accordance with the present disclosure, e.g., similar to assembly 340 of FIG. 3D. Assembly 640 is shown as having substrates 601 and 611 (having pluralities of conductive traces 607, 617, respectively) and core 620.

Assembly 600 further includes a main package 650 with a substrate 651 receiving first and second IC die 652, 653. The IC die 652, 653 may be mounted to substrate 651 using a suitable technique, e.g., wirebonds 658a-b, as shown. In some embodiments, substrate 651 can include a pair of lead frames 651a-b, as shown. Insulative molding (encapsulant) material 654 is shown as part of main package 650, e.g., forming the bulk of the body of the package.

Main package 650 can have a first plurality of leads 656a-656b adapted to receive (e.g., support and electrically connect to) transformer assembly 640 in a mounted position, as shown. Main package 650 can have a second plurality of leads 657a-657b adapted to connect main package 650 to another system or circuit, e.g., one that is present on another PCB. As shown, the mountain position of transformer assembly 640 on top of (stacked on) main package 650 leads to a compact assembly and can be accomplished without taking up additional area (footprint) relative to the main package 650 itself. In some embodiments, assembly 600 can be configured as a dual-inline-pin (DIP), small-outline IC (SOIC) combination.

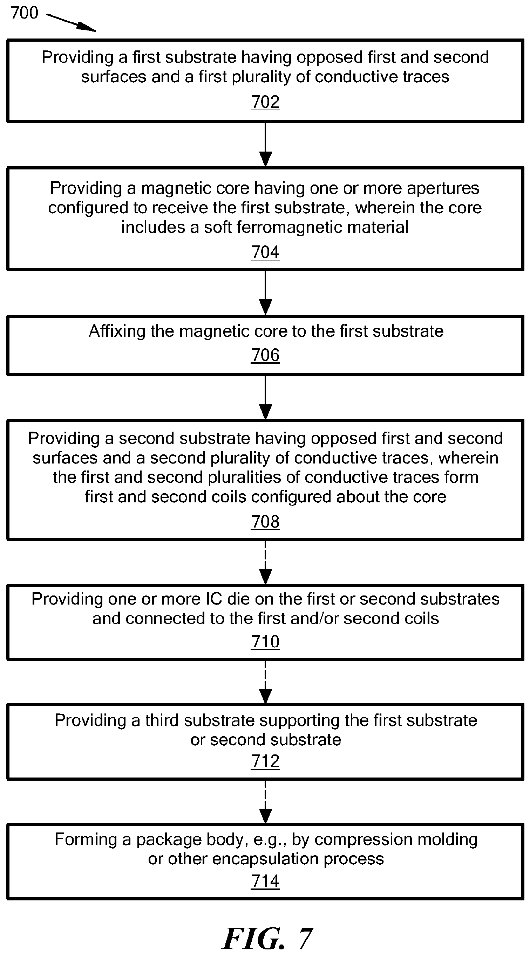

FIG. 7 is a diagram showing an example method of 700 fabricating winding-less transformer assemblies, in accordance with the present disclosure. Method 700 can include providing a first substrate having opposed first and second surfaces and a first plurality of conductive traces, as described at 702. In some embodiments, the substrate may be or include a PCB. A magnetic core can be provided having one or more apertures configured to receive the first substrate, wherein the core includes a soft ferromagnetic material, as described at 704. Affixing the magnetic core to the first substrate, as described at 706. Providing a second substrate having opposed first and second surfaces and a second plurality of conductive traces, wherein the first and second pluralities of conductive traces form first and second coils configured about the core, as described at 708.

One or more IC die can be provided, e.g., mounted to the first or second substrates and connected to the first and/or second coils, as described at 710. The die may be connected to a substrate by a suitable technique or process, e.g., in some embodiments, die can be connected with ball or stud technology or with wire bonds. A third substrate can be provided which supports the first substrate and/or second substrate, as described at 712. A package body can be formed, e.g., by compression molding or other encapsulation process, as an optional step, as described at 714. The package body may encapsulate or cover the core and fractional coil structures of the transformer. In some embodiments, one or more IC die (packaged or unpackaged) can be provided to the substrate. For example, in some embodiments first and second IC die can be provided to the substrate prior to the optional body-formation/encapsulation step (at 714). In some embodiment, the second IC die can include a gate driver.

As stated above, fabrication/construction process/method according to the present disclosure can be performed operation-by-operation on multiple sub-panels (e.g., subunits) of a larger panel (e.g., PCB). For example, some embodiments of a fabrication/construction process/method, e.g., method 700, can utilize a manufactured slot in a substrate/PCB to hold a transformer core (e.g., made of ferrite, iron, or other appropriate material). For example, in some embodiments of a fabrication/construction process/method, a substrate (e.g., PCB such as or similar to substrate 201 of FIG. 2) can first be placed with glue applied at designated locations, as a first step. In some embodiments, individual cores can then be placed onto the pre-glued substrate (e.g., PCB) and then be cured. In some embodiments, individual cores can be placed onto a substrate (e.g., PCB) and then using a post applied adhesion method, such as jetting or needle dispensed. In some embodiments, individual cores can be placed onto a substrate (e.g., PCB) that has some form of friction interface or crush ribs of some form

In some embodiments of a fabrication/construction process/method, cores may be placed first and then a substrate or substrates are placed. For example, in some embodiments, cores can be placed onto a tray (that might contain recesses), followed by sliding a substrate (e.g., larger PCB panel with smaller subunits) over the multiple elements (cores). In some embodiments, the tray may have a mechanism/method to mechanically lock the magnets (cores) in place. In some embodiments, the tray could contain vacuum to hold magnets in place. In some embodiments, magnets (cores) can be placed with pick and place technology. In some embodiments, magnets (cores) could be seated with vibratory methods to seat into appropriate sockets. In some embodiments, magnets (cores) can be designed to be shape- optimized to only fall into pockets in a particular way, etc.

In some examples and/or embodiments, conductive features of the primary and secondary sides of a transformer structure in a transformer sub-assembly, transformer assembly or transformer package according to the present disclosure can be fabricated or configured to have a desired separation distance (d) between certain parts or features, e.g., to meet internal creepage or external clearance requirements for a given pollution degree rating as defined by certain safety standards bodies such as the Underwriters Laboratories (UL) and the International Electrotechnical Commission (IEC). For example, a separation distance may be between closest (voltage) points of the respective circuits, e.g., the low-voltage (primary) side and high-voltage (secondary) side.

In some examples and embodiments, a dielectric material (e.g., gel) may be used for potting and/or protecting substrate (e.g., PCB) systems, assemblies, and/or packages, to protect die, magnetic cores, and/or interconnects from environment conditions (e.g., shocks, vibrations, or other applied forces) and/or to provide dielectric insulation.

Accordingly, embodiments and/or examples of the inventive subject matter can afford various benefits relative to prior art techniques. For example, embodiments and examples of the present disclosure can enable or facilitate lower costs, greater robustness, and/or higher scalability for manufacturing of IC packages/modules having voltage-isolated (galvanic isolation) IC die and transformers.

Various embodiments of the concepts, systems, devices, structures, and techniques sought to be protected are described above with reference to the related drawings. Alternative embodiments can be devised without departing from the scope of the concepts, systems, devices, structures, and techniques described. For example, in some embodiments, primary and/or secondary transformer coils may have a whole number or a fractional number of turns (loops or structures configured around a related magnetic core), e.g., 1.5, 2.5, 1.75, 1.8, 2.25, 5, 6.5, 8.8, etc.

It is noted that various connections and positional relationships (e.g., over, below, adjacent, etc.) may be used to describe elements and components in the description and drawings. These connections and/or positional relationships, unless specified otherwise, can be direct or indirect, and the described concepts, systems, devices, structures, and techniques are not intended to be limiting in this respect. Accordingly, a coupling of entities can refer to either a direct or an indirect coupling, and a positional relationship between entities can be a direct or indirect positional relationship.

As an example of an indirect positional relationship, positioning element "A" over element "B" can include situations in which one or more intermediate elements (e.g., element "C") is between elements "A" and elements "B" as long as the relevant characteristics and functionalities of elements "A" and "B" are not substantially changed by the intermediate element(s).

Also, the following definitions and abbreviations are to be used for the interpretation of the claims and the specification. The terms "comprise," "comprises," "comprising," "include," "includes," "including," "has," "having," "contains" or "containing," or any other variation are intended to cover a non-exclusive inclusion. For example, an apparatus, a method, a composition, a mixture, or an article, which includes a list of elements is not necessarily limited to only those elements but can include other elements not expressly listed or inherent to such apparatus, method, composition, mixture, or article.

Additionally, the term "exemplary" means "serving as an example, instance, or illustration." Any embodiment or design described as "exemplary" is not necessarily to be construed as preferred or advantageous over other embodiments or designs. The terms "one or more" and "at least one" may indicate any integer number greater than or equal to one, i.e., one, two, three, four, etc.; those terms, however, may refer to fractional numbers/values where context admits, e.g., a number of loops in a transformer coil may be a plurality that includes a fractional value, e.g., 2.75, 3.5, 4.25, etc. The term "plurality" may indicate any integer number greater than or equal to two, i.e., two, three, four, etc.; that term, however, may refer to fractional numbers/values greater than one, e.g., 1.2, 1.8, 2.66, etc., where context admits. The term "connection" can include an indirect connection and a direct connection.

References in the specification to "embodiments," "one embodiment, "an embodiment," "an example embodiment," "an example," "an instance," "an aspect," etc., indicate that the embodiment described can include a particular feature, structure, or characteristic, but every embodiment may or may not include the particular feature, structure, or characteristic. Moreover, such phrases do not necessarily refer to the same embodiment. Further, when a particular feature, structure, or characteristic is described in connection with an embodiment, it may affect such feature, structure, or characteristic in other embodiments whether explicitly described or not.

Relative or positional terms including, but not limited to, the terms "upper," "lower," "right," "left," "vertical," "horizontal, "top," "bottom," and derivatives of those terms relate to the described structures and methods as oriented in the drawing figures. The terms "overlying," "atop," "on top, "positioned on" or "positioned atop" mean that a first element, such as a first structure, is present on a second element, such as a second structure, where intervening elements such as an interface structure can be present between the first element and the second element. The term "direct contact" means that a first element, such as a first structure, and a second element, such as a second structure, are connected without any intermediary elements.

Use of ordinal terms such as "first," "second," "third," etc., in the claims to modify a claim element does not by itself connote any priority, precedence, or order of one claim element over another, or a temporal order in which acts of a method are performed but are used merely as labels to distinguish one claim element having a certain name from another element having a same name (but for use of the ordinal term) to distinguish the claim elements.

The terms "approximately" and "about" may be used to mean within ±20% of a target (or nominal) value in some embodiments, within plus or minus (±) 10% of a target value in some embodiments, within ±5% of a target value in some embodiments, and yet within ±2% of a target value in some embodiments. The terms "approximately" and "about" may include the target value. The term "substantially equal" may be used to refer to values that are within ±20% of one another in some embodiments, within ±10% of one another in some embodiments, within ±5% of one another in some embodiments, and yet within ±2% of one another in some embodiments.

The term "substantially" may be used to refer to values that are within ±20% of a comparative measure in some embodiments, within ±10% in some embodiments, within ±5% in some embodiments, and yet within ±2% in some embodiments. For example, a first direction that is "substantially" perpendicular to a second direction may refer to a first direction that is within ±20% of making a 90° angle with the second direction in some embodiments, within ±10% of making a 90° angle with the second direction in some embodiments, within ±5% of making a 90° angle with the second direction in some embodiments, and yet within ±2% of making a 90° angle with the second direction in some embodiments.

The disclosed subject matter is not limited in its application to the details of construction and to the arrangements of the components set forth in the following description or illustrated in the drawings. The disclosed subject matter is capable of other embodiments and of being practiced and implemented in various ways.

Also, the phraseology and terminology used in this patent are for the purpose of description and should not be regarded as limiting. As such, the conception upon which this disclosure is based may readily be utilized as a basis for the designing of other structures, methods, and systems for carrying out the several purposes of the disclosed subject matter. Therefore, the claims should be regarded as including such equivalent constructions as far as they do not depart from the spirit and scope of the disclosed subject matter.

Although the disclosed subject matter has been described and illustrated in the foregoing exemplary embodiments, the present disclosure has been made only by way of example. Thus, numerous changes in the details of implementation of the disclosed subject matter may be made without departing from the spirit and scope of the disclosed subject matter.

Accordingly, the scope of this patent should not be limited to the described implementations but rather should be limited only by the spirit and scope of the following claims.

All publications and references cited in this patent are expressly incorporated by reference in their entirety.

## Claims

1. A transformer package having fractional coil components, the transformer package comprising:
a first substrate having opposed first and second surfaces, and including a first plurality of conductive traces;
a magnetic core including soft ferromagnetic material, wherein the magnetic core includes an aperture receiving a portion of the first substrate; and
a second substrate having opposed first and second surfaces, and including a second plurality of conductive traces;
wherein the first plurality of conductive traces and the second plurality of conductive traces are configured when in contact with each other to form first and second coils configured about the magnetic core.

2. The transformer package of claim 1, further comprising an encapsulant disposed about at least a portion of the first substrate, the second substrate, or the magnetic core.

3. The transformer package of claim 1, further comprising one or more integrated circuit (IC) die connected to the first coil and/or second coil.

4. The transformer package of claim 1, further comprising a third substrate configured to support the first substrate and the second substrate.

5. The transformer package of claim 1, further comprising an adhesive disposed between the first substrate and core portion for facilitating affixing of the magnetic core to the first substrate.

6. A method of making a transformer package having fractional coil components, the method comprising:
providing a first substrate having first and second surfaces and including a first plurality of conductive traces;
providing a magnetic core having an aperture configured to receive the first substrate, wherein the magnetic core includes a soft ferromagnetic material;
affixing the magnetic core to the first substrate;
providing a second substrate having opposed first and second surfaces and a second plurality of conductive traces; and
connecting the first plurality of conductive traces and the second plurality of conductive traces, wherein the first and second pluralities of conductive traces form first and second coils configured about the magnetic core.

7. The method of claim 6, further comprising providing one or more IC die connected to the first and/or second coils.

8. The method of claim 6, further comprising applying an encapsulant disposed about at least a portion of the first substrate, the second substrate, or the magnetic core.

9. The method of claim 8, or the transformer package of claim 2, wherein the encapsulant forms one or more surfaces of a package body.

10. The method of claim 8, or the transformer package of claim 2, wherein the encapsulant comprises a molding material.

11. The method of claim 6, or the transformer package of claim 1, wherein the aperture comprises first and second apertures and wherein the first substrate includes two portions received by the first and second apertures, respectively.

12. The method of claim 6, or the transformer package of claim 1, wherein the second substrate includes a recess configured to receive the magnetic core.

13. The method of claim 6, or the transformer package of claim 1, wherein the first substrate and/or second substrate comprises a printed circuit board (PCB).

14. The method of claim 6, further comprising providing one or more integrated circuit (IC) die connected to the first coil and/or second coil.

15. The method of claim 14, or the transformer package of claim 3, wherein the first and second coils are configured as a step up transformer, and wherein the one or more IC die comprise a gate driver connected to the second coil.

16. The method of claim 6, further comprising providing a third substrate configured to support the first substrate and the second substrate.

17. The method of claim 16, or the transformer package of claim 4, wherein the third substrate comprises a lead frame.

18. The method of claim 16, further comprising providing an adhesive disposed between the first substrate and the magnetic core for facilitating affixing of the magnetic core to the first substrate.

19. The method of claim 6, or the transformer package of claim 1, wherein the magnetic core comprises ferrite.
